# EUROPEAN PATENT APPLICATION

(11) **EP 4 761 112 A1**
(43) Date of publication of application: **17.06.2026**
(21) Application number: 24852053.8
(22) Date of filing: 27.06.2024
(51) Int. Cl.: H03K 3/57, H03K 4/02, H01J 37/32

(54) **MULTI-STEP PULSE DC WAVEFORM GENERATOR**

(30) Priority: 09.08.2023 KR 20230104112
(71) Applicant: MKS KOREA LTD., Giheung-gu Yongin-si, Gyeonggi-do 17086 (KR)
(72) Inventor: JUNG, Jae Chul, Sejong 30115 (KR); JUNG, Jung Hwa, Sejong 30101 (KR); MIN, Ju Hwa, Daejeon 34311 (KR)
(74) Representative: MKS IP Association
(86) International application number: PCT/KR2024/008953
(87) International publication number: WO 2025/033697

(57) **Abstract**

A pulse generating apparatus according to an embodiment of the present disclosure includes a pulse DC generator configured to provide a pulse DC waveform to a capacitively coupled load; a step waveform generator configured to provide a step waveform to the capacitively coupled load and connected parallel with the pulse DC generator; and a controller configured to control the pulse DC waveform of the pulse DC generator and the step waveform of the step waveform generator. A waveform applied to the capacitively coupled load includes a first falling period in which a voltage decreases from a positive voltage to a negative first voltage, a first holding period in which the voltage is maintained at the negative first voltage for a predetermined time, a second falling period in which the voltage decreases from the first voltage to a second voltage, and a second holding period in which the voltage is maintained at the second voltage.

## Description

### [Technical Field]

The present disclosure relates to a pulse DC waveform generating apparatus, and more particularly, to a multi-step pulse DC waveform generating apparatus with a negative voltage at frequencies ranging from tens to hundreds of kHz to control ion energy during a plasma process.

### [Background Art]

Recently, semiconductor processes have required advanced technologies such as high-precision technology for forming fine patterns and rapid substrate processing. In semiconductor processes, plasma is generally generated by an RF generating apparatus operating at a frequency of 2 MHz or higher. To increase the processing speed of semiconductor processes, various methods are used, such as increasing the power of the RF generator or changing the frequency of the RF generator. More specifically, a first power supply unit that generates plasma by supplying power of several hundred watts or more at a frequency of 1 MHz or higher and supplies appropriate plasma particles to a substrate as a reaction target is used together with a second power supply unit that has a frequency range of several tens to several hundred kHz and has the main purpose of accelerating the generated plasma particles and injecting them into a semiconductor substrate to be processed.

Recently, semiconductor processes have required advanced technologies such as high-precision technology for forming fine patterns and rapid substrate processing. In the semiconductor processes, plasma is generally generated by an RF generator operating at a frequency of 2 MHz or higher. To increase the processing speed of semiconductor processes, various methods are used, such as increasing the power of the RF generating apparatus or changing the frequency of the RF generating apparatus. More specifically, a first power supply device that generates plasma by supplying power of several hundred watts or more at a frequency of 1 MHz or higher and supplies appropriate plasma particles to a substrate as a reaction target is used together with a second power supply device that has a frequency range of tens to hundreds of kHz to control the energy of the generated plasma particles and inject them into the semiconductor substrate.

Conventional RF generating apparatuses may be classified as a first power supply device, a second power supply device, or a third power supply device depending on their respective purposes. Such typical RF generating apparatuses supply sinusoidal power to a plasma load. However, it is well known that a power supply device for supplying ion energy to a semiconductor process substrate, especially in the plasma, using a sinusoidal power supply device, has a wide energy range in the ion energy distribution of the plasma due to the sinusoidal characteristics of the supplied power.

This conventional ion energy distribution causes problems in etching uniformity, etch selectivity, and etch pattern distortion in increasingly advanced semiconductor processes with feature sizes of several nanometers (nm) to several tens of nanometers or less. In addition, these problems may adversely affect the yield of semiconductor devices.

In contrast, a pulse DC generator, as one approach for satisfying the requirements of such high-precision and high-miniaturization semiconductor processes, may control the incident energy of ions incident on the substrate from the plasma by applying a non-sinusoidal voltage waveform. The pulse DC generator is characterized by applying a pulse voltage waveform to the plasma load, rather than supplying a sinusoidal voltage to the plasma load or the semiconductor process substrate.

The conventional pulse DC generating apparatus, which generates square waves, is widely known and used, along with the sinusoidal wave generating apparatus, even in applications beyond the semiconductor industry. However, when the pulse DC generator that generates these simple square waves is used for ion energy control in semiconductor plasma reaction processes, a phenomenon occurs in which the absolute value of the voltage of a wafer or substrate decreases over time. This decrease in wafer voltage may cause an ion energy distribution function (IEDF) to spread over a wide energy range. Therefore, in the case of simple square pulse waveforms, control of the ion energy distribution has limitations.

Accordingly, the pulse DC voltage generated by the pulse DC generator proposed in the present disclosure is not a simple pulse waveform such as a square wave but rather has a step-shaped waveform with a negative voltage. The present disclosure provides a multi-step pulse generating apparatus. The multi-step pulse generating apparatus may control the ion energy distribution of plasma, thereby enabling a more efficient plasma process operation.

### [Detailed Description of Invention]

### [Technical Problem]

One technical problem to be solved by the present disclosure is directed to providing a pulse DC waveform generating apparatus for controlling ion energy to provide an ion energy distribution having at least two peaks.

### [Technical Solution]

A pulse generating according to an embodiment of the present disclosure includes: a pulse DC generator configured to provide a pulse DC waveform to a capacitively coupled load; a step waveform generator configured to provide a step waveform to the capacitively coupled load and connected parallel with the pulse DC generator; and a controller configured to control the pulse DC waveform of the pulse DC generator and the step waveform of the step waveform generator, wherein a waveform applied to the capacitively coupled load includes a first falling period in which a voltage decreases from a positive voltage to a negative first voltage, a first holding period in which the voltage is maintained at the negative first voltage for a predetermined time, a second falling period in which the voltage decreases from the negative first voltage to a second voltage, and a second holding period in which the voltage is maintained at the second voltage.

In an embodiment of the present disclosure, the pulse DC generator may include a first source stage including at least one of a first voltage source and a first current source; and a first switching stage configured to switch an output of the first source stage and output the switched output.

In an embodiment of the present disclosure, the first switching stage may be a half-bridge converter, a full-bridge converter, a three-level neutral point clamped converter (3L-NPC), a three-level active neutral point clamped converter (3L-ANPC), or a multi-level converter.

In an embodiment of the present disclosure, the step waveform generator may include a second source stage including at least one of a second voltage source and a second current source; and a second switching stage configured to switch an output of the second source stage and output the switched output.

In an embodiment of the present disclosure, the second switching stage may be a half-bridge converter, a full-bridge converter, a 3L-NPC, a 3L-ANPC, or a multi-level converter.

In an embodiment of the present disclosure, the pulse DC generator may form, at the capacitively coupled load, a first falling period in which a voltage decreases from a positive voltage to a negative first voltage. The step waveform generator may provide, at the capacitively coupled load, a first holding period in which the voltage is maintained at the first voltage, a second falling period in which the voltage decreases from the first voltage to a second voltage, and a second holding period in which the voltage is maintained at the second voltage.

In an embodiment of the present disclosure, the second current source may provide a step current, and the second switching stage may provide the step current to the capacitively coupled load during the second falling period.

In an embodiment of the present disclosure, the step current may form a ramp waveform at the capacitively coupled load, and the ramp waveform may provide an ion flux between a first energy peak caused by the first voltage and a second energy peak caused by the second voltage.

In an embodiment of the present disclosure, the step waveform generator may include a plurality of sub-step waveform generators. Each of the sub-step waveform generators may include a second source stage including a second voltage source; and a second switching stage connected to the second voltage source, and the outputs of the sub-step waveform generators may be connected to each other in a cascading manner.

In an embodiment of the present disclosure, the pulse DC waveform generator may include a plurality of sub-pulse DC waveform generators. Each of the sub-pulse DC waveform generators may include a first source stage including a first voltage source; and a first switching stage connected to the first voltage source, and the outputs of the sub-pulse DC waveform generators may be connected to each other in a cascading manner.

In an embodiment of the present disclosure, the step waveform generator may include a plurality of sub-step waveform generators. Each of the sub-step waveform generators may include a second source stage including a second current source; and a second switching stage connected to the second current source, and the outputs of the sub-step waveform generators may be connected to each other in parallel.

In an embodiment of the present disclosure, the second switching stage may include a first transistor and a second transistor connected parallel with an output terminal of the second current source; a first diode connected between the first transistor and ground; and a second diode connected to the second transistor in series, and the output of the second switching stage may be provided through the second transistor and the second diode.

In an embodiment of the present disclosure, the step waveform generator may include a first sub-step waveform generator and a second sub-step waveform generator. The first sub-step waveform generator may provide a first step current, and the second sub-step waveform generator may provide a second step current different from the first step current.

In an embodiment of the present disclosure, the first step current may form a first ramp waveform at the capacitively coupled load, and the second step current may form a second ramp waveform at the capacitively coupled load.

In an embodiment of the present disclosure, the pulse DC generator may include a first source stage including a first current source; and a first switching stage configured to switch an output of the first source stage and output the switched output. The step waveform generator may include a second source stage including a second current source; and a second switching stage configured to switch an output of the second source stage and output the switched output.

In an embodiment of the present disclosure, the pulse DC generator may provide a pulse current, and may control an application time of the pulse current to control an ion flux according to ion energy.

In an embodiment of the present disclosure, the step waveform generator may provide a step current, and may control an application time of the step current to control an ion flux according to ion energy.

In an embodiment of the present disclosure, the waveform applied to the capacitively coupled load may further include a third falling period in which the voltage decreases from the second voltage to a third voltage, and a third holding period in which the voltage is maintained at the third voltage for a predetermined time.

A pulse generating apparatus according to an embodiment of the present disclosure includes: a pulse DC generator configured to provide a pulse DC waveform to a capacitively coupled load; a step waveform generator configured to provide a step waveform to the capacitively coupled load and connected parallel with the pulse DC generator; and a controller configured to control the pulse DC waveform of the pulse DC generator and the step waveform of the step waveform generator, wherein a waveform applied to the capacitively coupled load includes a first falling period in which a voltage decreases from a positive voltage to a negative first voltage, a first holding period in which the voltage is maintained at the negative first voltage for a predetermined time, a second falling period in which the voltage decreases from the first voltage to a second voltage, and a second holding period in which the voltage is maintained at the second voltage. A method of operating the pulse generating apparatus includes: setting the pulse DC waveform and the step waveform; forming the pulse DC waveform at the capacitively coupled load by operating the pulse DC generator; and forming the step waveform at the capacitively coupled load by operating the step waveform generator. The pulse DC waveform may include a first falling period in which a voltage decreases from the positive voltage to a negative first voltage. The step waveform may include a first holding period in which the voltage is maintained at the negative first voltage for a predetermined time, a second falling period in which the voltage decreases from the first voltage to a second voltage, and a second holding period in which the voltage is maintained at the second voltage.

A pulse generating apparatus according to an embodiment of the present disclosure includes: a pulse DC generator configured to provide a pulse DC waveform to a capacitively coupled load; a step waveform generator configured to provide a step waveform to the capacitively coupled load and connected parallel with the pulse DC generator; a switching unit configured to switch the outputs of the pulse DC generator and the step waveform generator; and a controller configured to control the pulse DC generator and the step waveform. A waveform applied to the capacitively coupled load may include a first falling period in which a voltage decreases from a positive voltage to a negative first voltage, a first holding period in which the voltage is maintained at the negative first voltage for a predetermined time, a second falling period in which the voltage decreases from the negative first voltage to a second voltage, and a second holding period in which the voltage is maintained at the second voltage.

In an embodiment of the present disclosure, a pulse DC generator 710 may branch from an output terminal of a current source rectifier 705 and may be connected to one end of a first inductor 712 to generate a pulse current Ip, and a step waveform generator 720 may branch from the output terminal of the current source rectifier 705 and may be connected to one end of a second inductor 722 to generate a step current Is.

In an embodiment of the present disclosure, the pulse DC generator 710 includes: a first transistor having a source connected to the other end of the first inductor 712; a second transistor having a source connected to the other end of the first inductor 712; and a first diode connected to a drain of the first transistor in series. The first diode may be connected to one end of the first inductor 712, and a drain of the second transistor may be connected to an input terminal of the switching unit.

In an embodiment of the present disclosure, the step waveform generator may include: a third transistor having a source connected to the other end of the second inductor; a fourth transistor having a source connected to the other end of the second inductor; and a second diode connected to a drain of the third transistor in series. The second diode may be connected to the one end of the second inductor, and a drain of the fourth transistor is connected to an input terminal of the switching unit.

In an embodiment of the present disclosure, the switching unit may include: a fifth transistor connected to an output terminal of the pulse DC generator; a sixth transistor connected to the fifth transistor in series; a seventh transistor connected to the output terminal of the pulse DC generator; an eighth transistor connected to the seventh transistor in series; a first inverter diode disposed between the fifth transistor and the output terminal of the pulse DC generator; a second inverter diode disposed between the fifth transistor and the sixth transistor; a third inverter diode disposed between the seventh transistor and the output terminal of the pulse DC generator; and a fourth inverter diode disposed between the seventh transistor and the eighth transistor. A node between the fifth transistor and the second diode may be connected to one end of the load, and a node between the seventh transistor and the fourth diode may be connected to the other end of the load.

A pulse DC waveform generating apparatus according to an embodiment of the present disclosure may control a bi-modal ion energy distribution function (IEDF) over a range from a low ion energy flux to a high ion energy flux by controlling ion energy.

A pulse DC waveform generating apparatus according to an embodiment of the present disclosure may control, as key control variables, a low ion energy level and a peak thereof, a high ion energy level and a peak thereof, a width of the low energy and a width of the high energy, and a flux of incident ion energy in an intermediate energy band between the two energy levels.

### [Advantageous Effects]

A pulse DC waveform generating apparatus according to an embodiment of the present disclosure can control a bi-modal ion energy distribution function (IEDF) over a range from a low ion energy flux to a high ion energy flux by controlling ion energy.

A pulse DC waveform generating apparatus according to an embodiment of the present disclosure can control, as key control variables, a low ion energy level and a peak thereof, a high ion energy level and a peak thereof, a width of the low energy and a width of the high energy, and a flux of incident ion energy in an intermediate energy band between the two energy levels.

### [Description of Drawings]

FIG. 1 is a conceptual diagram illustrating a plasma processing apparatus according to an embodiment of the present disclosure.
FIG. 2A is a conceptual diagram illustrating a pulse generating apparatus according to an embodiment of the present disclosure.
FIGS. 2B and 2C are graphs illustrating an output voltage of the pulse generating apparatus of FIG. 2A and an ion flux according to ion energy.
FIG. 3 is a conceptual diagram and an output waveform illustrating a pulse DC generator according to another embodiment of the present disclosure.
FIG. 4 is a conceptual diagram illustrating a first source stage of the pulse DC generator of FIG. 3.
FIG. 5 is a conceptual diagram illustrating a pulse DC generator according to an embodiment of the present disclosure.
FIG. 6A is a conceptual diagram illustrating a pulse DC generator according to an embodiment of the present disclosure.
FIG. 6B is a conceptual diagram illustrating a pulse DC generator according to an embodiment of the present disclosure.
FIG. 7 is a conceptual diagram illustrating a step waveform generator according to an embodiment of the present disclosure.
FIG. 8 is a conceptual diagram illustrating a second source stage of a step waveform generator according to an embodiment of the present disclosure.
FIG. 9 is a conceptual diagram illustrating a second switching stage of a step waveform generator according to an embodiment of the present disclosure.
FIGS. 10A and 10B are conceptual diagrams illustrating a second switching stage of a step waveform generator according to an embodiment of the present disclosure.
FIGS. 11 and 12 are diagrams illustrating a pulse generating apparatus according to another embodiment of the present disclosure.
FIGS. 13 and 14 are diagrams illustrating a pulse generating apparatus according to still another embodiment of the present disclosure.
FIGS. 15 and 16 are diagrams illustrating a pulse generating apparatus according to yet another embodiment of the present disclosure.
FIGS. 17 and 18 are diagrams illustrating a pulse generating apparatus according to yet another embodiment of the present disclosure.
FIGS. 19 and 20 are diagrams illustrating a pulse generating apparatus according to yet another embodiment of the present disclosure.
FIGS. 21 and 22 are diagrams illustrating a pulse generating apparatus according to yet another embodiment of the present disclosure.
FIG. 23 is a flowchart illustrating a method of operating a pulse generating apparatus according to an embodiment of the present disclosure.
FIG. 24 is a conceptual diagram illustrating a pulse generating apparatus according to another embodiment of the present disclosure.
FIG. 25 is a circuit diagram illustrating a pulse DC generator and a step waveform generator of the pulse generating apparatus of FIG. 24.
FIG. 26 is a timing diagram illustrating a waveform applied to a load of the pulse generating apparatus of FIG. 24.
FIGS. 27 and 28 are diagrams illustrating current paths of the pulse DC generator and the step waveform generator of FIG. 25.

### [Modes of the Invention]

A pulse generating apparatus according to an embodiment of the present disclosure includes: a pulse DC generator configured to provide a pulse DC waveform to a capacitively coupled load; a step waveform generator configured to provide a step waveform to the capacitively coupled load and connected parallel with the pulse DC generator; and a controller configured to control the pulse DC waveform of the pulse DC generator and the step waveform of the step waveform generator.

Each of the pulse DC generator and the step waveform generator may be a current-type generator that outputs current or a voltage-type generator that outputs voltage. Each of the pulse DC generator and the step waveform generator may output voltage and current simultaneously.

The pulse generating apparatus according to an embodiment of the present disclosure may provide a pulse DC to a semiconductor processing substrate of a capacitively coupled plasma generating apparatus or to a semiconductor processing substrate of an inductively coupled plasma generating apparatus or an electron cyclotron resonance (ECR) plasma generating apparatus, which is not shown in the present disclosure, or to semiconductor processing substrates of other plasma generating apparatuses, thereby controlling the ion energy distribution during the plasma process and increasing efficiency of the plasma process.

Hereinafter, exemplary embodiments of the present disclosure will be described in detail with reference to the accompanying drawings. However, the present disclosure is not limited to the embodiments described herein and may be embodied in other forms. Rather, the embodiments introduced herein are provided to ensure that the disclosure is thorough and complete, and to sufficiently convey the spirit of the present disclosure to those skilled in the art. In the drawings, components are exaggerated for clarity. Like reference numbers designate like elements throughout the specification.

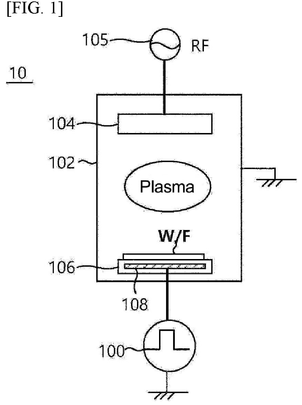

FIG. 1 is a conceptual diagram illustrating a plasma processing apparatus according to an embodiment of the present disclosure.

Referring to FIG. 1, a plasma processing apparatus 10 includes a chamber 102 configured to form a vacuum region, an upper electrode 104 disposed in the chamber 102 and configured to receive RF power to generate plasma, a substrate holder 106 configured to face the upper electrode 104 and mount a substrate W/F, an electrode 108 disposed in the substrate holder 106, and a pulse generating apparatus 100 configured to apply a pulse DC waveform to the electrode 108.

An RF generator 105 generates plasma by applying sinusoidal RF power to the upper electrode 104. The RF generator 105 may use a frequency higher than that of the pulse generating apparatus. The frequency of the RF generator 105 may be generally 2 MHz or higher, and the power value may range from hundreds of watts to tens of kilowatts depending on a corresponding process. The RF generator 105 may supply power to the upper electrode 104 in a pulsed manner such that the RF generator 105 operates for a predetermined period of time and remains inactive for a predetermined period of time or in the form of multi-step pulses in which the applied power varies over time.

A plasma semiconductor processing apparatus may generally be classified into a capacitively coupled plasma (CCP) structure and an inductively coupled plasma (ICP) structure. Plasma generated within a chamber may be used to perform various plasma processes depending on variables such as the type and pressure of gas. Although the detailed description of the present disclosure will be described based on the CCP structure, the present disclosure is applicable to all plasma generating apparatuses for semiconductor processing, including both CCP and ICP structures.

The pulse generating apparatus 100 is connected to the electrode 108 of the substrate holder 106. That is, the pulse generating apparatus 100 may apply a pulse waveform to a capacitively coupled load. The pulse generating apparatus 100 serves to control ion energy incident on a substrate. That is, ions incident on the substrate W/F may have two or more energy peaks.

The substrate W/F is separated from the electrode 108 by an insulator. When the substrate W/F is treated as a conductor, the electrode, the insulator, and the substrate form a capacitor. Plasma has a plasma potential, and a potential difference between the potential of the substrate and the plasma potential may determine the energy of ions incident on the substrate W/F.

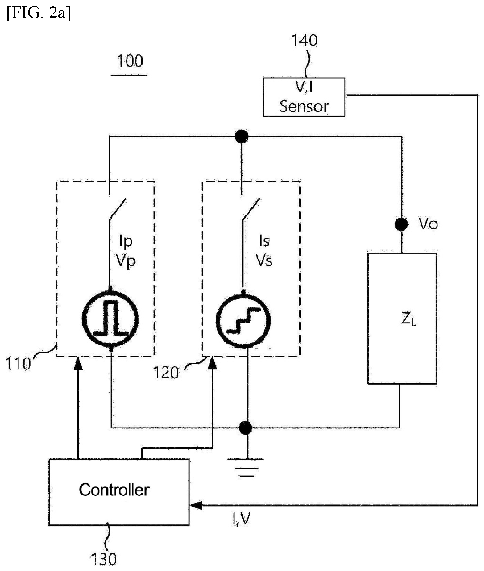

FIG. 2A is a conceptual diagram illustrating a pulse generating apparatus according to an embodiment of the present disclosure.

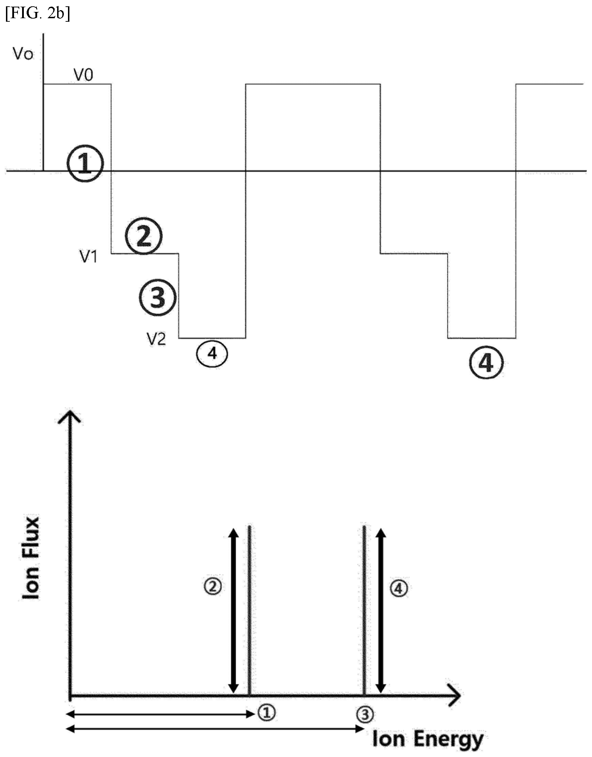

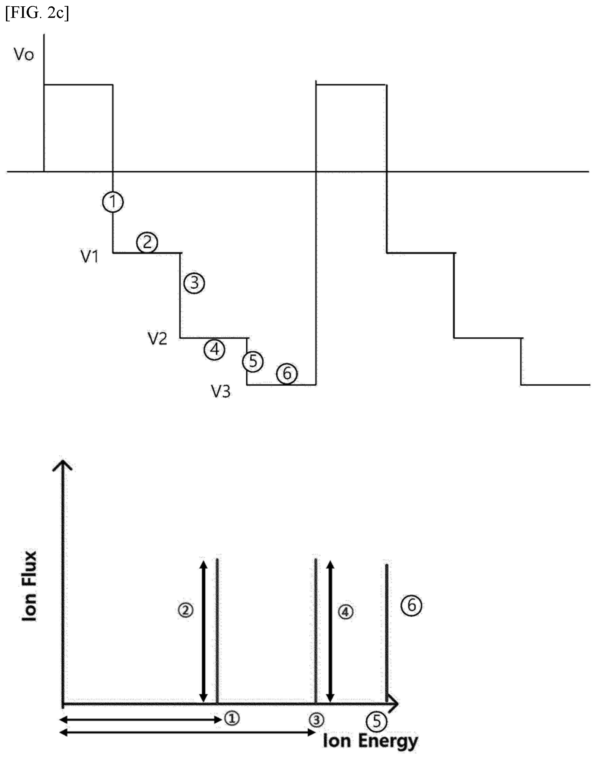

FIGS. 2B and 2C are graphs illustrating an output voltage of the pulse generating apparatus of FIG. 2A and an ion flux according to ion energy.

Referring to FIGS. 2A, 2B, and 2C, a pulse generating apparatus 100 includes a pulse DC generator 110 configured to provide a pulse DC waveform to a capacitively coupled load Z_{L}; a step waveform generator 120 configured to provide a step waveform to the capacitively coupled load Z_{L} and connected parallel with the pulse DC generator 110; and a controller 130 configured to control the pulse DC waveform of the pulse DC generator 110 and the step waveform of the step waveform generator 120. A waveform applied to the capacitively coupled load Z_{L} includes a first falling period ① in which a voltage decreases from a positive voltage V0 to a negative first voltage V1, a first holding period ② in which the voltage is maintained at the negative first voltage V1 for a predetermined time, a second falling period ③ in which the voltage decreases from the first voltage V1 to a second voltage V2, and a second holding period ④ in which the voltage is maintained at the second voltage V2.

In a multi-step pulse DC waveform generating apparatus 100 according to an embodiment of the present disclosure, a first pulse amplitude V0-V1, defined by a positive voltage V0 and a negative first voltage V1, determines relatively low ion energy.

The first holding period ② of the first pulse determines the peak of the incident ion flux with the ion energy determined by the first pulse amplitude V0-V1. That is, as the first holding period ② of the first pulse increases, the peak of the ion flux increases.

The second pulse amplitude V0-V2, defined by the positive voltage V0 and the negative second voltage V2, determines relatively high ion energy.

The second holding period ④ of the second pulse determines the peak of the incident ion flux with the ion energy determined by the second pulse amplitude V0-V2. That is, as the second holding period ④ of the second pulse increases, the peak of the ion flux increases.

The capacitively coupled load Z_{L} may include the electrode 108 that forms a capacitor with the substrate. The substrate W/F may be a semiconductor substrate. Plasma may be formed on the substrate W/F using another energy application means.

The pulse DC generator 110 may include: a first source stage 112 including a first voltage source and/or a first current source; and a first switching stage 114 configured to switch an output of the first source stage and output the switched output. The first switching stage 112 may be a half-bridge converter, a full-bridge converter, a three-level neutral point clamped converter (3L-NPC), a three-level active neutral point clamped converter (3L-ANPC), or a multi-level converter. The pulse DC generator 110 may form a first falling period in which a voltage decreases from a positive voltage V0 to a negative first voltage V1. The pulse DC generator 110 may increase the voltage from the negative first voltage V1 to the positive voltage V0.

The step waveform generator 120 may include a second source stage 122 including a second voltage source and/or a second current source; and a second switching stage 124 configured to switch an output of the second source stage 122 and output the switched output. The second switching stage 124 may be a half-bridge converter, a full-bridge converter, a 3L-NPC converter, a 3L-ANPC converter, or a multi-level converter.

The step waveform generator 120 may provide a first holding period in which a voltage is maintained at the first voltage V1, a second falling period in which the voltage decreases from the first voltage V1 to a second voltage V2, and a second holding period in which the voltage is maintained at the second voltage V2.

The controller 130 may control the pulse DC generator 110 to form the pulse DC waveform. The pulse DC waveform may have a square wave with the positive voltage V0 and the negative first voltage V1.

The controller 130 may control the step waveform generator 120 to form the step waveform. The step waveform may include at least one period in which a voltage decreases. The pulse DC waveform and the step waveform may be synchronized. The step waveform may be formed only during a period in which the pulse DC waveform has a negative voltage. The step waveform generated by the step waveform generator 120 may be synchronized with the pulse DC waveform.

A sensor unit 140 may sense a voltage Vo and/or a current at an output terminal of the pulse generating apparatus 100. The sensor unit 140 may sense the voltage Vo applied to the capacitively coupled load Z_{L} and provide the sensed voltage to the controller 130. The controller 130 may control the step waveform or the pulse DC waveform based on the sensed voltage.

Referring to FIG. 2C, a waveform applied to the capacitively coupled load includes a first falling period ① in which a voltage decreases from a positive voltage V0 to a negative first voltage V1, a first holding period ② in which the voltage is maintained at the negative first voltage V1 for a predetermined time, a second falling period ③ in which the voltage decreases from the first voltage V1 to a second voltage V2, a second holding period ④ in which the voltage is maintained at the second voltage V2, a third falling period ⑤ in which the voltage decreases from the second voltage V2 to a third voltage V3, and a third holding period ⑥ in which the voltage is maintained at the third voltage V3 for a predetermined time.

A third pulse amplitude V0-V3, defined by the positive voltage V0 and the negative third voltage V3, determines relatively high ion energy.

The third holding period ⑥ of the third pulse determines the peak of the incident ion flux with the ion energy determined by the third pulse amplitude V0-V3. That is, as the third holding period ⑥ of the third pulse increases, the peak of the ion flux increases.

Accordingly, a peak energy and a peak height of the ion flux are determined by the number of steps and durations of the holding periods.

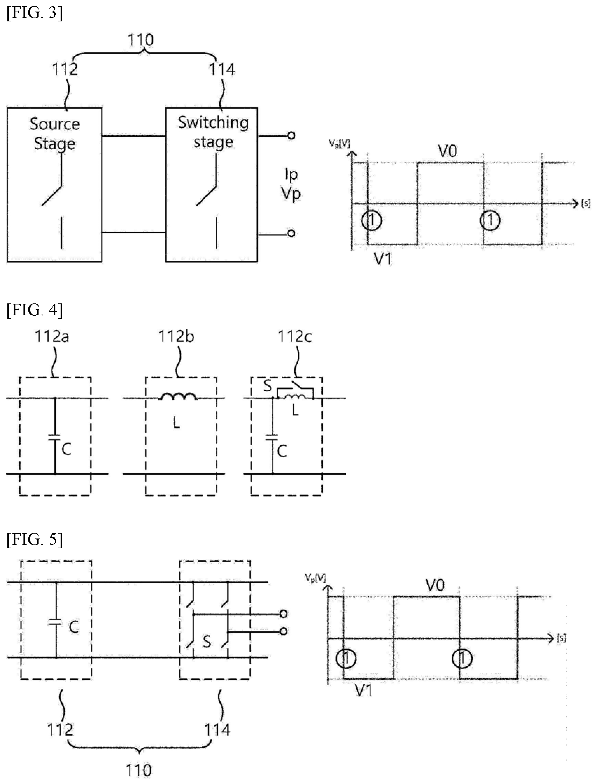

FIG. 3 is a conceptual diagram and an output waveform illustrating a pulse DC generator according to another embodiment of the present disclosure.

Referring to FIG. 3, a pulse DC generator 110 may include a first source stage 112 including a first voltage source and/or a first current source, and a first switching stage 114 configured to switch an output of the first source stage 112 and output the switched output. The first switching stage 114 may be a half-bridge converter, a full-bridge converter, a 3L-NPC, a 3L-ANPC, or a multi-level converter. The pulse DC waveform may be a square wave having a positive voltage V0 and a negative first voltage V1.

FIG. 4 is a conceptual diagram illustrating a first source stage of the pulse DC generator of FIG. 3.

Referring to FIG. 4, a first source stage 112a may be a voltage source including a capacitor C between a pair of output terminals. A first source stage 112b may be a current source including an inductor L at a positive output terminal, and a first source stage 112c may be a current and voltage source including a capacitor C between a pair of output terminals and including an inductor L and a switch S connected in parallel with each other at a positive output terminal.

FIG. 5 is a conceptual diagram illustrating a pulse DC generator according to an embodiment of the present disclosure.

Referring to FIG. 5, a pulse DC generator 110 may include a first source stage 112 including a first voltage source, and a first switching stage 114 configured to switch an output of the first source stage 112 and output the switched output. The first switching stage 114 may be a full-bridge converter.

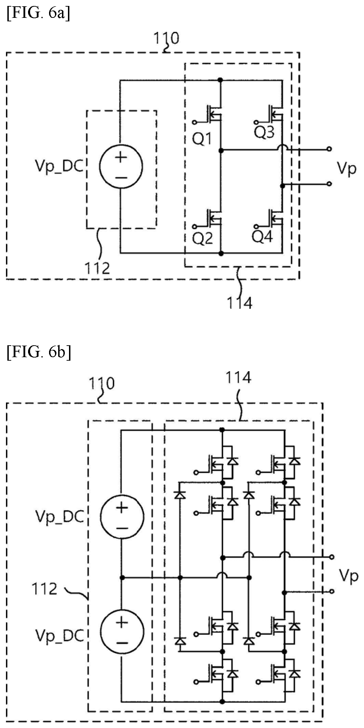

FIG. 6A is a conceptual diagram illustrating a pulse DC generator according to an embodiment of the present disclosure.

Referring to FIG. 6A, a pulse DC generator 110 may include a first source stage 112 including a first voltage source, and a first switching stage 114 configured to switch an output of the first source stage 112 and output the switched output. The first switching stage 114 may be a full-bridge converter.

FIG. 6B is a conceptual diagram illustrating a pulse DC generator according to an embodiment of the present disclosure.

Referring to FIG. 6B, a pulse DC generator 110 may include a first source stage 112 including a pair of first voltage sources, and a first switching stage 114 configured to switch an output of the first source stage 112 and output the switched output. The first switching stage 114 may be a 3L-NPC.

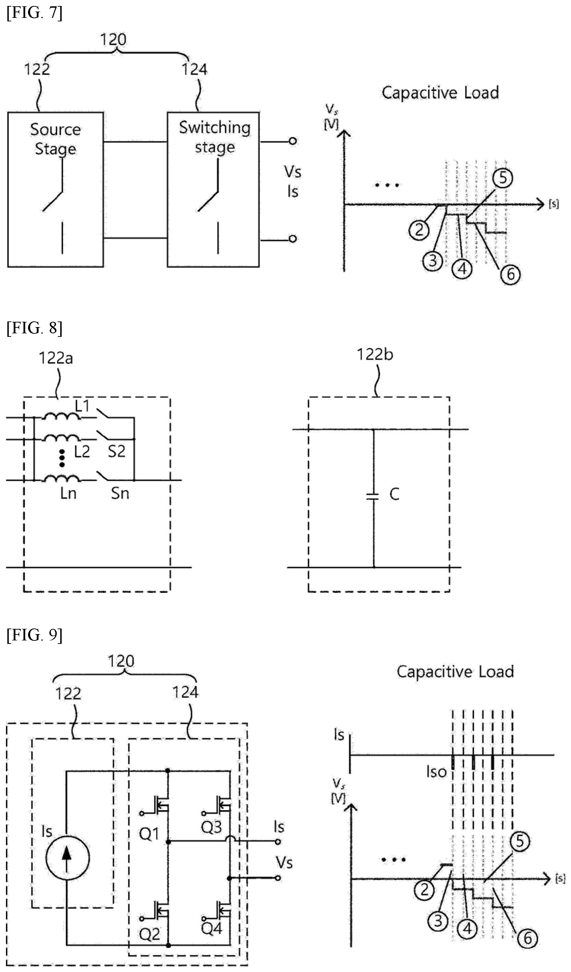

FIG. 7 is a conceptual diagram illustrating a step waveform generator according to an embodiment of the present disclosure.

Referring to FIG. 7, a step waveform generator 120 may include a second source stage 122 including a second voltage source and/or a second current source, and a second switching stage 124 configured to switch an output of the second source stage 122 and output the switched output. The second switching stage 124 may be a half-bridge converter, a full-bridge converter, a (3L-NPC, a 3L-ANPC, or a multi-level converter. For a capacitively coupled load, an output voltage Vs of the step waveform generator 120 may have a step shape in which a negative voltage decreases over time.

FIG. 8 is a conceptual diagram illustrating a second source stage of a step waveform generator according to an embodiment of the present disclosure.

Referring to FIG. 8, a second source stage 122a may include a plurality of inductors L1 and switches S1 connected in series with each other. The inductors L1 and switches S1 connected in series may provide step currents. To provide different step currents, the plurality of inductors L1 and switches S1 connected in series with each other may be provided. The plurality of series-connected inductors and switches may be connected in parallel with each other. Accordingly, the current stored in each inductor may be delivered to the second switching stage 124 via the switches.

Referring to FIG. 8, a second source stage 122b may be a voltage source including a capacitor C between a pair of output terminals.

FIG. 9 is a conceptual diagram illustrating a second switching stage of a step waveform generator according to an embodiment of the present disclosure.

Referring to FIG. 9, a step waveform generator 120 may include a second source stage 122 including a second current source, and a second switching stage 124 configured to switch an output of the second source stage 122 and output the switched output. The second switching stage 124 may be a full-bridge converter. The second current source may output a constant step current Is.

The second switching stage 124 may periodically output the step current Is over time and apply it to the capacitively coupled load Z_{L}. Accordingly, the step current Is appears as a step-shaped voltage Vs at the capacitively coupled load Z_{L}.

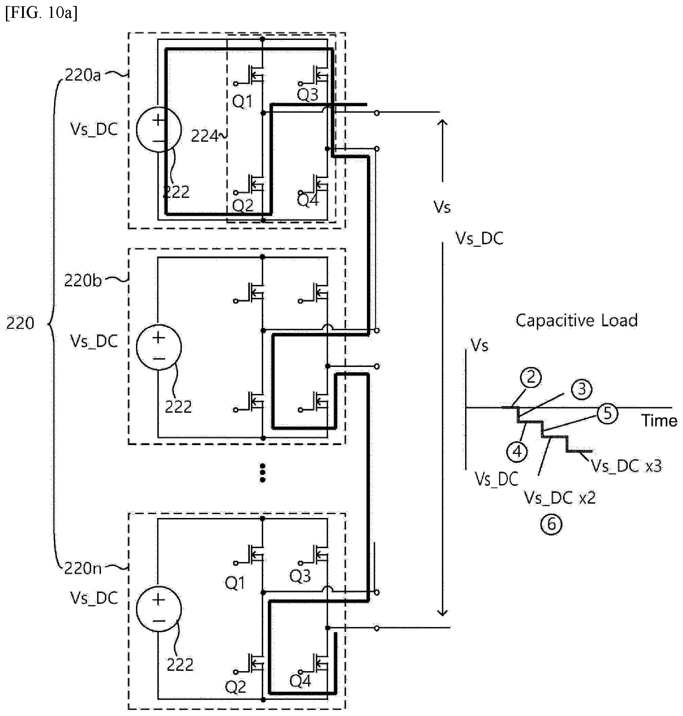

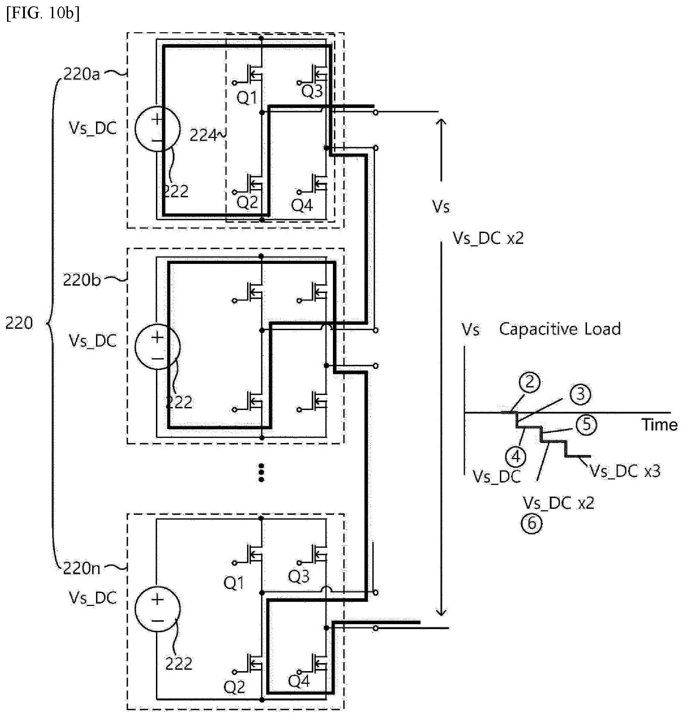

FIGS. 10A and 10B are conceptual diagrams illustrating a second switching stage of a step waveform generator according to an embodiment of the present disclosure.

Referring to FIG. 10A, a step waveform generator 220 may include a plurality of sub-step waveform generators 220a to 220n. Each of the sub-step waveform generators 220a to 220n includes a second source stage 222 including a second voltage source, and a second switching stage 224 connected to the second voltage source. Outputs of the plurality of sub-step waveform generators 220a to 220n are connected to each other in a cascading manner.

A negative output power of the first sub-step waveform generator 220a may be connected to a positive output power of a second sub-step waveform generator 220b. In addition, a negative output power of the second sub-step waveform generator 220b may be connected to a positive output power of a third sub-step waveform generator.

In order for an output voltage Vs_DC of the second voltage source of the first sub-step waveform generator 220a to operate as the output voltage Vs of the step waveform generator 220, the second switching stage 224 may provide a current path as indicated by the red line. That is, in the second switching stage 224 of the second to n-th sub-step waveform generators, the lower transistors Q2 and Q4 may be turned on, so that the voltage of the voltage source may not be applied to the output terminals of the sub-step waveform generators 220b to 220n.

Referring to FIG. 10B, in order for an output voltage Vs_DC of the second voltage source of the first sub-step waveform generator 220a and an output voltage Vs_DC of the second voltage source of the second sub-step waveform generator 220b to operate as an output voltage Vs_DC X 2 of the step waveform generator 220, the second switching stage 224 may provide a current path, as indicated by the red line. That is, in the second switching stage 224 of the third to n-th sub-step waveform generators, the lower transistors Q2 and Q4 may be turned on, so that the voltage of the voltage source may not be applied to the output terminals of the sub-step waveform generators.

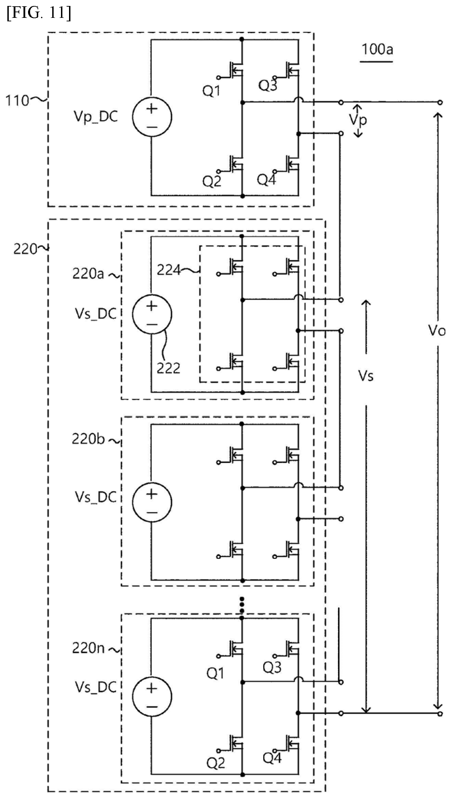

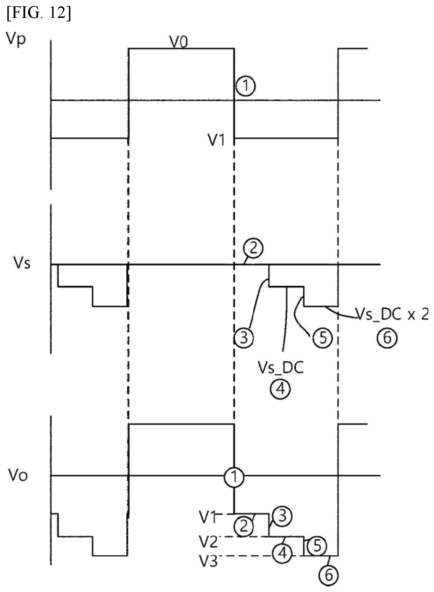

FIGS. 11 and 12 are diagrams illustrating a pulse generating apparatus according to another embodiment of the present disclosure.

Referring to FIGS. 11 and 12, a pulse generating apparatus 100a includes: a pulse DC generator 110 configured to provide a pulse DC waveform to a capacitively coupled load Z_{L}; a step waveform generator 220 connected parallel with the pulse DC generator 110 and configured to provide a step waveform to the capacitively coupled load Z_{L}; and a controller 130 configured to control the pulse DC waveform of the pulse DC generator 110 and the step waveform of the step waveform generator 220. A waveform applied to the capacitively coupled load Z_{L} includes a first falling period ① in which a voltage decreases from a positive voltage to a negative first voltage, a first holding period ② in which the voltage is maintained at the negative first voltage for a predetermined time, a second falling period ③ in which the voltage decreases from the first voltage to a second voltage, and a second holding period ④ in which the voltage is maintained at the second voltage.

The step waveform generator 220 may include a plurality of sub-step waveform generators 220a to 220n. Each of the sub-step waveform generators 220a to 220n includes a second source stage 222 including a second voltage source, and a second switching stage 224 connected to the second voltage source. Outputs of the sub-step waveform generators 220a to 220n are connected to each other in a cascading manner.

The pulse DC generator 110 may output a square wave having a positive voltage V0 and a negative first voltage V1.

The step waveform generator 220 may output a step-shaped voltage. The step waveform generator 220 may provide a first holding period ② in which a voltage is maintained at a first voltage V1, a second falling period ③ in which the voltage decreases from the first voltage V1 to a second voltage V2, a second holding period ④ in which a voltage is maintained at the second voltage V2, a third falling period ⑤ in which the voltage decreases from the second voltage V2 to a third voltage V3, and a third holding period ⑥ in which the voltage is maintained at the third voltage V3. A voltage difference between the first voltage V1 and the second voltage V2 may be a voltage difference Vs_DC of the second voltage source. A voltage difference between the second voltage V2 and the third voltage V3 may be a voltage difference Vs_DC of the second voltage source. The step waveform generator 220 may provide voltage steps corresponding to the number of sub-step waveform generators.

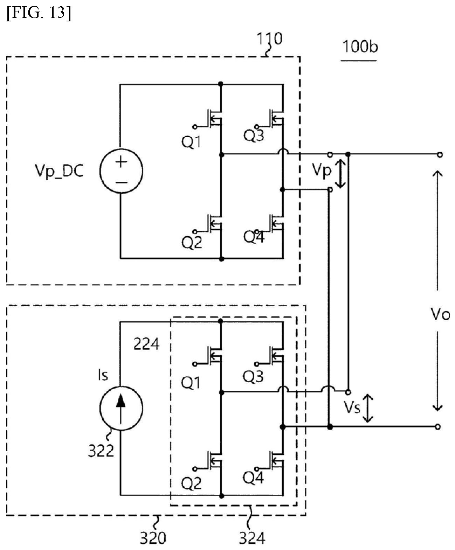

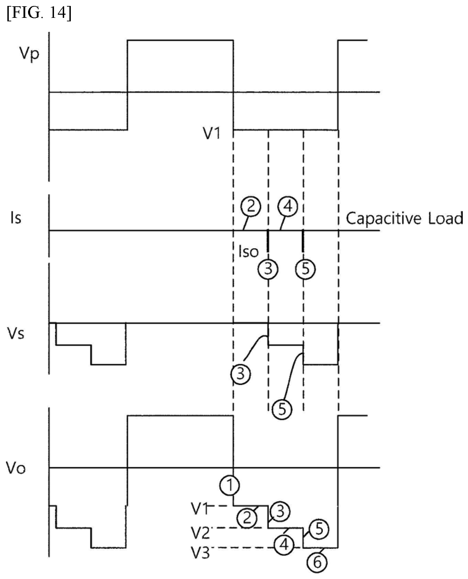

FIGS. 13 and 14 are diagrams illustrating a pulse generating apparatus according to still another embodiment of the present disclosure.

Referring to FIGS. 13 and 14, a pulse generating apparatus 100b includes a pulse DC generator 110 configured to provide a pulse DC waveform to a capacitively coupled load Z_{L}, a step waveform generator 320 configured to provide a step waveform to the capacitively coupled load Z_{L} and connected parallel with the pulse DC generator 110, and a controller 130 configured to control the pulse DC waveform of the pulse DC generator 110 and the step waveform of the step waveform generator 320. A waveform applied to the capacitively coupled load Z_{L} includes a first falling period ① in which a voltage decreases from a positive voltage V0 to a negative first voltage V1, a first holding period ② in which the voltage is maintained at the negative first voltage V1 for a predetermined time, a second falling period ③ in which the voltage decreases from the first voltage V1 to a second voltage V2, and a second holding period ④ in which the voltage is maintained at the second voltage V2.

The pulse DC generator 110 may output a square wave having a positive voltage V0 and a negative first voltage V1.

The step waveform generator 320 may include a second source stage 322 including a second current source, and a second switching stage 324 configured to switch an output of the second source stage 322 and output the switched output.

The step waveform generator 320 may output a pulsed step current Is. The pulsed step current Is may be converted into a step-shaped voltage at the capacitively coupled load Z_{L}.

The step waveform generator 320 may provide, at the load Z_{L}, a first holding period ② in which the voltage is maintained at a first voltage V1, a second falling period ③ in which the voltage decreases from the first voltage V1 to a second voltage V2, a second holding period ④ in which the voltage is maintained at the second voltage V2, a third falling period ⑤ in which the voltage decreases from the second voltage V2 to a third voltage V3, and a third holding period ⑥ in which the voltage is maintained at the third voltage V3. A voltage difference between the first voltage V1 and the second voltage V2 may depend on an amount of charge that is charged to the load Z_{L} by the step current Is and a capacitance of the load Z_{L}. A voltage difference between the second voltage V2 and the third voltage V3 may depend on an amount of charge that is charged to the load Z_{L} by the step current Is and a capacitance of the load Z_{L}. The step waveform generator 320 may provide voltage steps corresponding to the number of step currents Is.

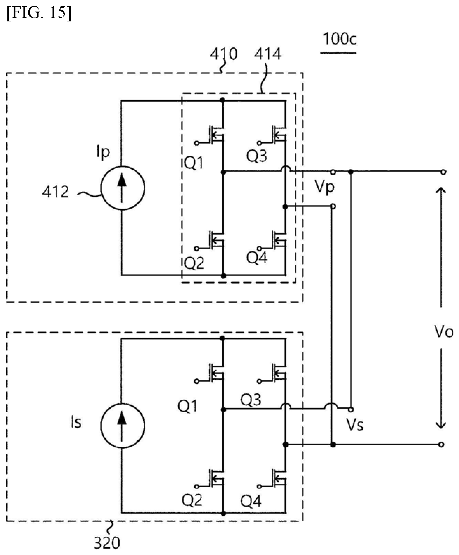

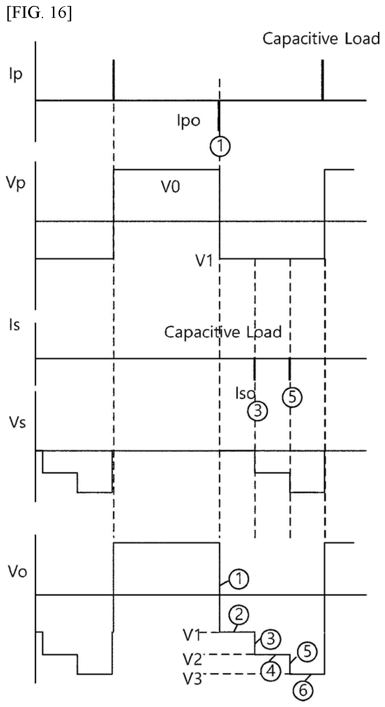

FIGS. 15 and 16 are diagrams illustrating a pulse generating apparatus according to yet another embodiment of the present disclosure.

Referring to FIGS. 15 and 16, a pulse generating apparatus 100c includes a pulse DC generator 410 configured to provide a pulse DC waveform to a capacitively coupled load Z_{L}, a step waveform generator 320 configured to provide a step waveform to the capacitively coupled load Z_{L} and connected parallel with the pulse DC generator 410, and a controller 130 configured to control the pulse DC waveform of the pulse DC generator 410 and the step waveform of the step waveform generator 320. A waveform applied to the capacitively coupled load Z_{L} includes a first falling period ① in which a voltage decreases from a positive voltage V0 to a negative first voltage V1, a first holding period ② in which the voltage is maintained at the negative first voltage V1 for a predetermined time, a second falling period ③ in which the voltage decreases from the first voltage V1 to a second voltage V2, and a second holding period ④ in which the voltage is maintained at the second voltage V2.

The pulse DC generator 410 may include a first source stage 412 including a first current source, and a first switching stage 414 configured to switch an output of the first source stage 412 and output the switched output. The pulse DC generator 410 may output a pulse current Ip. The pulse current Ip may be converted into a square-wave voltage Vp at the capacitively coupled load Z_{L}. A voltage difference between the positive voltage V0 and the first voltage V1 may depend on an amount of charge that is charged to the load Z_{L} by the pulse current Ip and a capacitance of the load Z_{L}.

The step waveform generator 320 may include a second source stage 322 including a second current source, and a second switching stage 324 configured to switch an output of the second source stage 322 and output the switched output. The step waveform generator 320 may output a pulse-shaped step current Is. The pulse-shaped step current Is may be converted into a step-shaped voltage Vs at the capacitively coupled load Z_{L}.

The step waveform generator 320 may provide, at the load Z_{L}, a first holding period ② in which a voltage is maintained at a first voltage V1, a second falling period ③ in which the voltage decreases from the first voltage V1 to a second voltage V2, a second holding period ④ in which the voltage is maintained at the second voltage V2, a third falling period ⑤ in which the voltage decreases from the second voltage V2 to a third voltage V3, and a third holding period ⑥ in which the voltage is maintained at the third voltage V3. A voltage difference between the first voltage V1 and the second voltage V2 may depend on an amount of charge that is charged to the load Z_{L} by the step current Is and a capacitance of the load Z_{L}. A voltage difference between the second voltage V2 and the third voltage V3 may depend on an amount of charge that is charged to the load Z_{L} by the step current Is and a capacitance of the load Z_{L}.

Each switching element may have inherent physical characteristics, which can be readily anticipated in actual implementation. The inherent physical characteristics may include on-off delay time, rising and falling time, circuit connection characteristics, and load characteristics. The circuit connection characteristics may include stray inductance, stray capacitance, and stray resistance.

Considering these inherent physical characteristics, time-varying characteristics of a potential may be present during a transition ① from a positive potential to a negative potential and during a transition ③ from the negative potential to a lower negative potential. Such time-varying characteristics may result in different ion energy distributions, and this may be controlled to obtain a desired ion energy distribution.

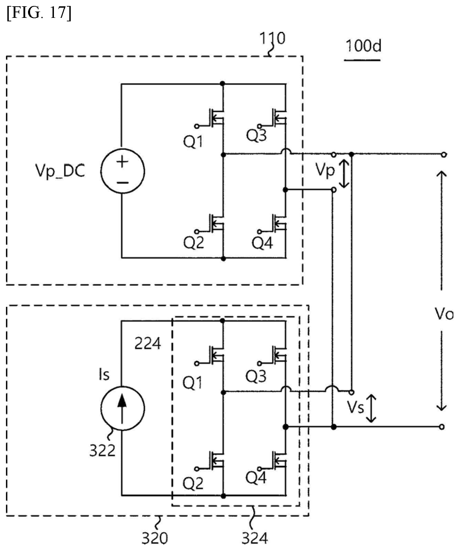

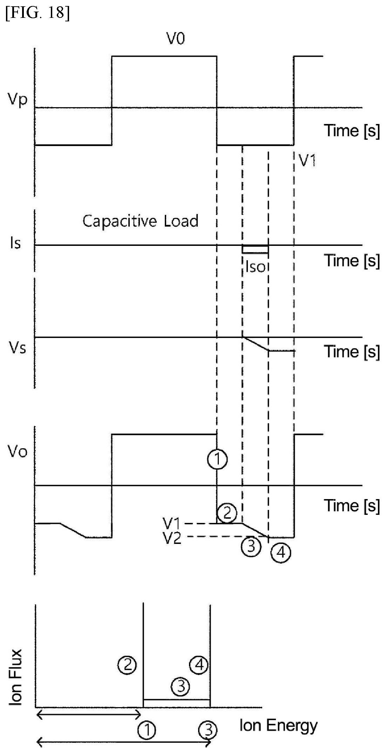

FIGS. 17 and 18 are diagrams illustrating a pulse generating apparatus according to yet another embodiment of the present disclosure.

Referring to FIGS. 17 and 18, a pulse generating apparatus 100d includes a pulse DC generator 110 configured to provide a pulse DC waveform to a capacitively coupled load Z_{L}, a step waveform generator 320 configured to provide a step waveform to the capacitively coupled load Z_{L} and connected parallel with the pulse DC generator 110, and a controller 130 configured to control the pulse DC waveform of the pulse DC generator 110 and the step waveform of the step waveform generator 320. A waveform applied to the capacitively coupled load Z_{L} includes a first falling period ① in which a voltage decreases from a positive voltage V0 to a negative first voltage V1, a first holding period ② in which the voltage is maintained at the negative first voltage V1 for a predetermined time, a second falling period ③ in which the voltage decreases from the first voltage V1 to a second voltage V2, and a second holding period ④ in which the voltage is maintained at the second voltage V3.

The pulse DC generator 110 may output a square wave having a positive voltage V0 and a negative first voltage V1.

The step waveform generator 320 may include a second source stage 322 including a second current source, and a second switching stage 324 configured to switch an output of the second source stage 322 and output the switched output.

The step waveform generator 320 may output a pulsed step current Iso. The pulsed step current Iso may be converted into a step-shaped voltage Vs at the capacitively coupled load Z_{L}.

The step waveform generator 320 may provide, at the load Z_{L}, a first holding period ② in which a voltage is maintained at a first voltage V1, a second falling period ③ in which the voltage decreases from the first voltage V1 to a second voltage V2, and a second holding period ④ in which the voltage is maintained at the second voltage V2. A voltage difference between the first voltage V1 and the second voltage V2 may depend on an amount of charge that is charged to the load by the step current Iso and a capacitance of the load.

During the second falling period ③ in which the voltage decreases from the first voltage V1 to the second voltage V2, the step current Iso may be maintained for a predetermined time. A step voltage waveform Vs generated by the step current Iso may have a predetermined slope. Accordingly, due to the slope of the step voltage Vs, an ion flux having intermediate energy between first ion energy corresponding to the first voltage V1 and second ion energy corresponding to the second voltage V2 may be provided. That is, the ion flux may have a predetermined energy range.

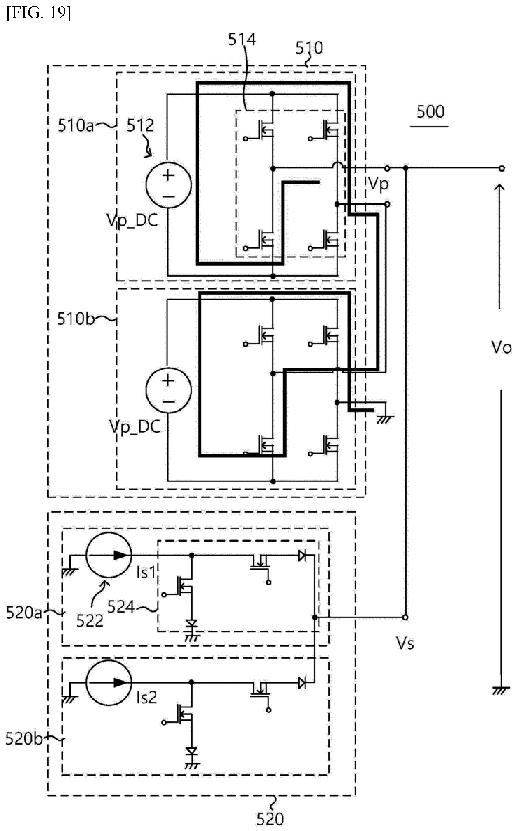

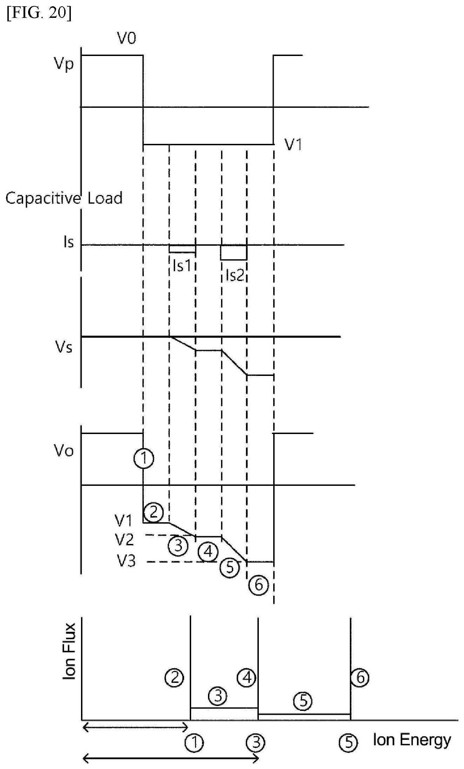

FIGS. 19 and 20 are diagrams illustrating a pulse generating apparatus according to yet another embodiment of the present disclosure.

Referring to FIGS. 19 and 20, a pulse generating apparatus 500 includes a pulse DC generator 510 configured to provide a pulse DC waveform to a capacitively coupled load Z_{L}, a step waveform generator 520 configured to provide a step waveform to the capacitively coupled load Z_{L} and connected parallel with the pulse DC generator 510, and a controller 130 configured to control the pulse DC waveform of the pulse DC generator 510 and the step waveform of the step waveform generator 520. A waveform applied to the capacitively coupled load Z_{L} includes a first falling period ① in which a voltage decreases from a positive voltage V0 to a negative first voltage V1, a first holding period ② in which the voltage is maintained at the negative first voltage V1 for a predetermined time, a second falling period ③ in which the voltage decreases from the first voltage V1 to a second voltage V2, and a second holding period ④ in which the voltage is maintained at the second voltage V2.

The pulse DC generator 510 may include a plurality of sub-pulse DC generators 510a and 510b. Each of the sub-pulse DC generators 510a and 510b may include a second source stage 512 including a first voltage source, and a second switching stage 514 connected to the second voltage source. Outputs of the sub-pulse DC generators 510a and 510b may be connected to each other in a cascading manner.

The pulse DC generator 510 may output a square wave having a positive voltage V0 and a negative first voltage V1.

The step waveform generator 520 may form a step-shaped voltage Vs at the capacitively coupled load. The step waveform generator 520 may provide a first holding period ② in which a voltage is maintained at a first voltage V1, a second falling period ③ in which the voltage decreases from the first voltage V1 to a second voltage V2, a second holding period ④ in which the voltage is maintained at the second voltage V2, a third falling period ⑤ in which the voltage decreases from the second voltage V2 to a third voltage V3, and a third holding period ⑥ in which the voltage is maintained at the third voltage V3.

The step waveform generator 520 may include a plurality of sub-step waveform generators 520a and 520b. Each of the sub-step waveform generators 520a and 520b may include a second source stage 522 including a second current source, and a second switching stage 524 connected to the second current source. Outputs of the sub-step waveform generators 520a and 520b may be connected to each other in parallel. The first sub-step waveform generator 520a may output a first step current Is1, and the second sub-step waveform generator 520b may output a second step current Is2.

During the second falling period ③ in which the voltage decreases from the first voltage V1 to the second voltage V2, the first step current Is1 may be maintained for a predetermined time. Accordingly, a step voltage generated by the first step current Is1 may have a predetermined slope. Due to the slope of the step voltage, an ion flux having first intermediate energy between first ion energy corresponding to the first voltage V1 and second ion energy corresponding to the second voltage V2 may be provided.

During the third falling period ⑤ in which the voltage decreases from the second voltage V2 to the third voltage V3, the second step current Is2 may be maintained for a predetermined time. Accordingly, a step voltage generated by the second step current Is2 may have a predetermined slope. Due to the slope of the step voltage, an ion flux having second intermediate energy between second ion energy corresponding to the second voltage V2 and third ion energy corresponding to the third voltage V3 may be provided. That is, the ion flux may have a predetermined energy range.

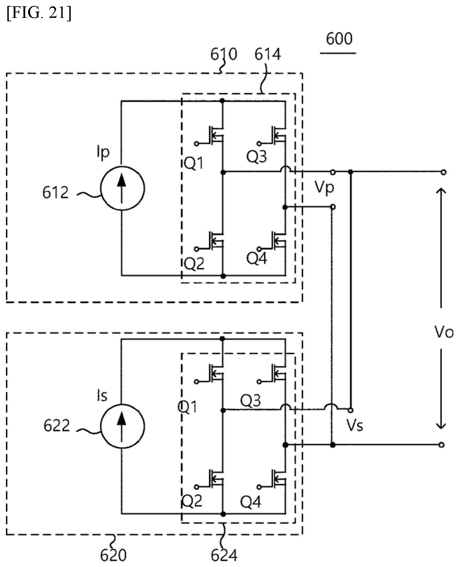

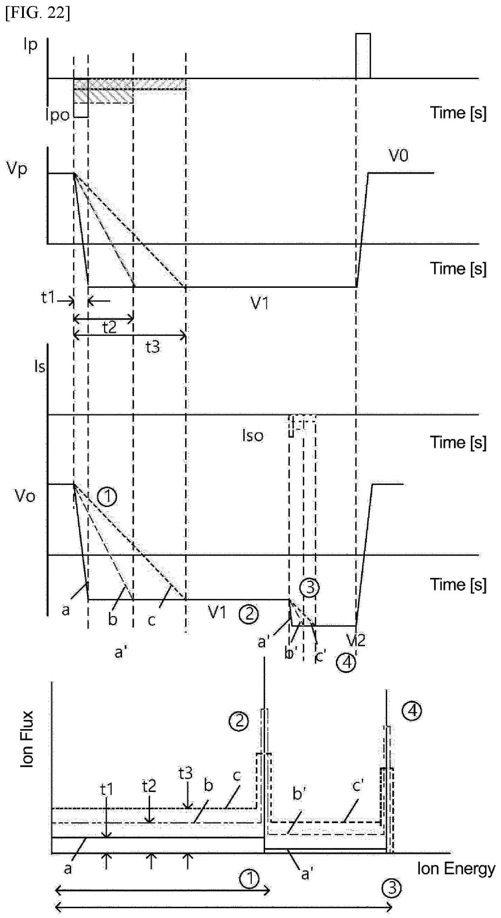

FIGS. 21 and 22 are diagrams illustrating a pulse generating apparatus according to yet another embodiment of the present disclosure.

Referring to FIGS. 21 and 22, a pulse generating apparatus 600 includes a pulse DC generator 610 configured to provide a pulse DC waveform to a capacitively coupled load Z_{L}, a step waveform generator 620 configured to provide a step waveform to the capacitively coupled load Z_{L} and connected parallel with the pulse DC generator 610, and a controller 130 configured to control the pulse DC waveform of the pulse DC generator 610 and the step waveform of the step waveform generator 620. A waveform applied to the capacitively coupled load Z_{L} includes a first falling period ① in which a voltage decreases from a positive voltage V0 to a negative first voltage V1, a first holding period ② in which the voltage is maintained at the negative first voltage V1 for a predetermined time, a second falling period ③ in which the voltage decreases from the first voltage V1 to a second voltage V2, and a second holding period ④ in which the voltage is maintained at the second voltage V2.

The pulse DC generator 610 may form a square wave having a positive voltage V0 and a negative first voltage V1 at the capacitively coupled load Z_{L}. The pulse DC generator 610 may include a first source stage 612 including a first current source, and a first switching stage 614 configured to switch an output of the first source stage 612 and output the switched output. The pulse DC generator 610 may output a pulse current Ipo for a predetermined time. The pulse current Ipo may be converted into a square-wave voltage Vp at the capacitively coupled load Z_{L}. A voltage difference between the positive voltage V0 and the first voltage V1 may depend on an amount of charge that is charged to the load by the pulse current Ipo and a capacitance of the load. An amplitude and a duration of the pulse current Ipo may provide a slope of the pulse voltage Vp. A first slope a, a second slope b, and a third slope c may be determined by different amplitudes and durations of the pulse current Ipo. The slope of the pulse voltage Vp may provide an offset between zero ion energy and first ion energy corresponding to the first voltage V1. The offset may depend on durations t1, t2, and t3 of the slope. The slope of the pulse voltage Vp may depend on electrical characteristics of the pulse DC generator 610.

The step waveform generator 620 may include a second source stage 622 including a second current source, and a second switching stage 624 configured to switch an output of the second source stage 622 and output the switched output.

The step waveform generator 620 may output a pulsed step current Iso. The pulsed step current Iso may be converted into a step-shaped voltage Vs at the capacitively coupled load Z_{L}.

The step waveform generator 620 may provide, at the load Z_{L}, a first holding period ② in which the voltage is maintained at a first voltage V1, a second falling period ③ in which the voltage decreases from the first voltage V1 to a second voltage V2, and a second holding period ④ in which the voltage is maintained at the second voltage V2. A voltage difference between the first voltage V1 and the second voltage V2 may depend on an amount of charge that is charged to the load by the step current Iso and a capacitance of the load.

During the second falling period ③ in which the voltage decreases from the first voltage V1 to the second voltage V2, the step current Iso may be maintained for a predetermined time. Accordingly, a step voltage waveform generated by the step current Iso may have predetermined slopes a', b', and c'. Due to the slopes a', b', and c' of the step voltage, an ion flux having intermediate energy between first ion energy corresponding to the first voltage V1 and second ion energy corresponding to the second voltage V2 may be provided. That is, the ion flux may have a predetermined energy range.

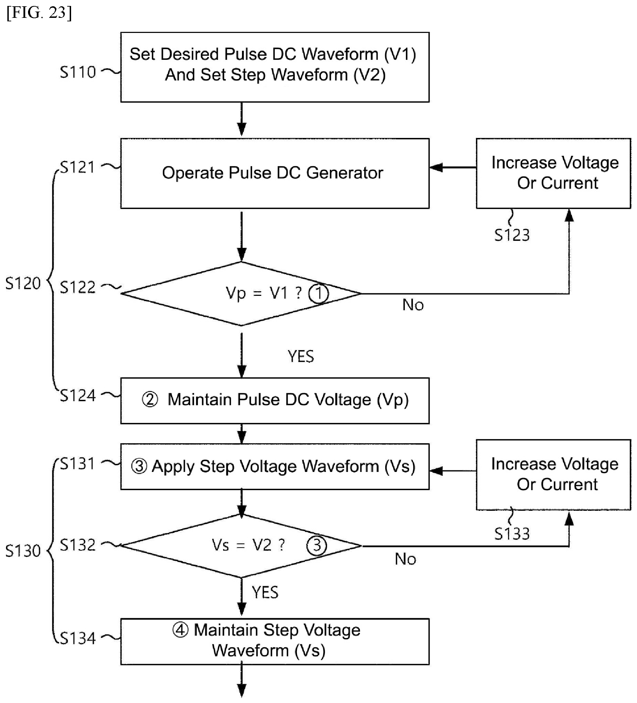

FIG. 23 is a flowchart illustrating a method of operating a pulse generating apparatus according to an embodiment of the present disclosure.

Referring to FIG. 23, a method of operating a pulse generating apparatus includes setting a pulse DC voltage waveform and a step voltage waveform in operation S110, applying a pulse DC voltage waveform Vp to a capacitively coupled load Z_{L} by operating a pulse DC generator 110 in operation S120, and applying a step voltage waveform Vs to the capacitively coupled load Z_{L} by operating a step waveform generator 120 in operation S120.

Operation S120 of applying the pulse DC voltage waveform Vp to the capacitively coupled load Z_{L} may include measuring a voltage of the capacitively coupled load using a voltage sensor and controlling a current or a voltage until the measured voltage reaches the set pulse DC voltage waveform in operations S122, S123, and S124.

Operation S130 of applying the step voltage waveform Vs to the capacitively coupled load Z_{L} by operating the step waveform generator 120 may include measuring the voltage of the capacitively coupled load Z_{L} using a voltage sensor and controlling a current or a voltage until the measured voltage reaches the set step voltage waveform Vs in operations S131, S132, S133, and S134.

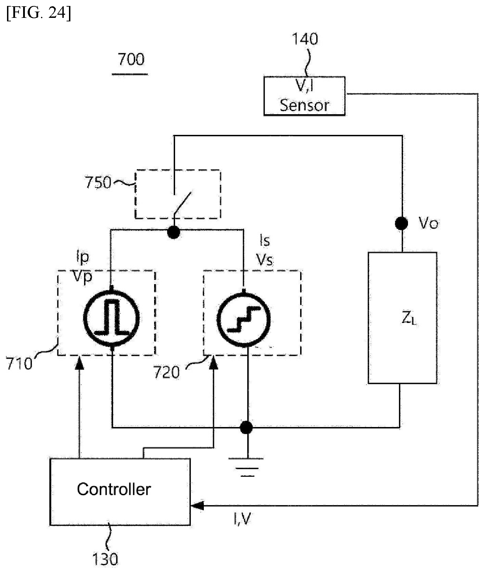

FIG. 24 is a conceptual diagram illustrating a pulse generating apparatus according to another embodiment of the present disclosure.

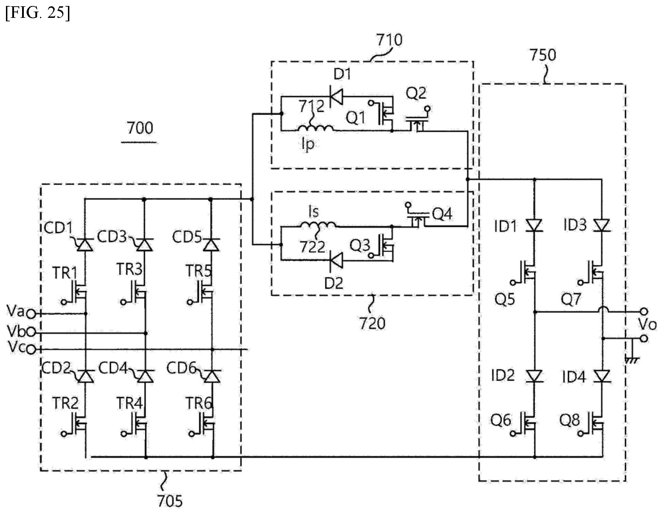

FIG. 25 is a circuit diagram illustrating a pulse DC generator and a step waveform generator of the pulse generating apparatus of FIG. 24.

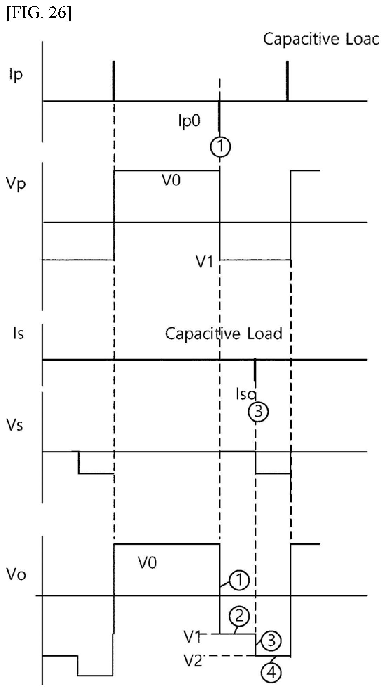

FIG. 26 is a timing diagram illustrating a waveform applied to a load of the pulse generating apparatus of FIG. 24.

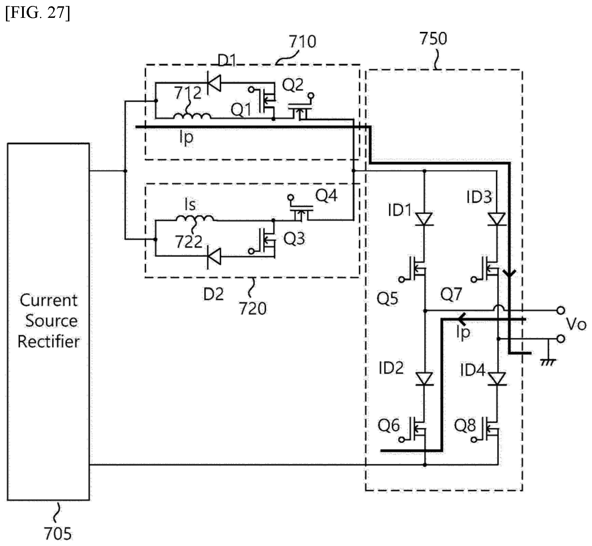

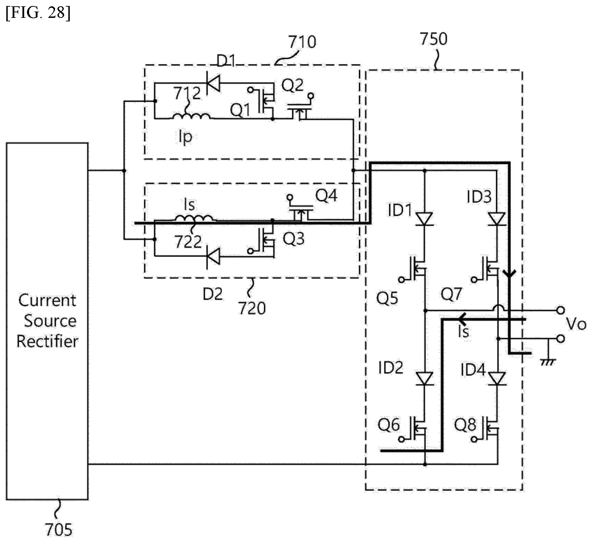

FIGS. 27 and 28 are diagrams illustrating current paths of the pulse DC generator and the step waveform generator of FIG. 25.

Referring to FIGS. 24 to 27, a pulse generating apparatus according to an embodiment of the present disclosure includes a pulse DC generator 710 configured to provide a pulse DC waveform to a capacitively coupled load Z_{L}, a step waveform generator 720 configured to provide a step waveform to the capacitively coupled load Z_{L} and connected parallel with the pulse DC generator, a switching unit 750 configured to switch outputs of the pulse DC generator and the step waveform generator, and a controller 130 configured to control the pulse DC generator 710 and the step waveform generator 720.

A waveform applied to the capacitively coupled load includes a first falling period ① in which a voltage decreases from a positive voltage V0 to a negative first voltage V1, a first holding period ② in which the voltage is maintained at the negative first voltage for a predetermined time, a second falling period ③ in which the voltage decreases from the first voltage to a second voltage, and a second holding period ④ in which the voltage is maintained at the second voltage.

The pulse DC generator 710 is branched from an output terminal of a current source rectifier 705 and connected to one end of a first inductor 712 to generate a pulse current Ip. The step waveform generator 720 is branched from the output terminal of the current source rectifier 705 and connected to one end of a second inductor 722 to generate a step current Is.

The pulse DC generator 710 includes a first transistor Q1 having a source connected to the other end of the first inductor 712, a second transistor Q2 having a source connected to the other end of the first inductor 712, and a first diode D1 connected to a drain of the first transistor Q1 in series. The first diode D1 is connected to the one end of the first inductor 712, and a drain of the second transistor Q2 is connected to an input terminal of the switching unit 750.

The step waveform generator 720 includes a third transistor Q3 having a source connected to the other end of the second inductor 722, a fourth transistor Q4 having a source connected to the other end of the second inductor 722, and a second diode D2 connected to a drain of the third transistor Q3 in series. The second diode D2 is connected to the one end of the second inductor 722, and a drain of the fourth transistor Q4 is connected to the input terminal of the switching unit 750.

The switching unit 750 includes a fifth transistor Q5 connected to an output terminal of the pulse DC generator 710, a sixth transistor Q6 connected to the fifth transistor Q5 in series, a seventh transistor Q7 connected to the output terminal of the pulse DC generator 710, an eighth transistor Q8 connected to the seventh transistor Q7 in series, a first inverter diode ID1 disposed between the fifth transistor Q5 and the output terminal of the pulse DC generator 710, a second inverter diode ID2 disposed between the fifth transistor Q5 and the sixth transistor Q6, a third inverter diode ID3 disposed between the seventh transistor Q7 and the output terminal of the pulse DC generator 710, and a fourth inverter diode ID4 disposed between the seventh transistor Q7 and the eighth transistor Q8.

A node between the fifth transistor Q5 and the second inverter diode ID2 is connected to one end of the load Z_{L}. A node between the seventh transistor Q7 and the fourth inverter diode ID4 is connected to the other end of the load Z_{L}.

A three-phase power source may be connected to the current source rectifier 705. The three-phase power source may include a first terminal Va, a second terminal Vb, and a third terminal Vc having a phase difference of 120 degrees from each other.

The current source rectifier 705 may include a first diode CD1, a first control switch TR1, a second diode CD2, and a second control switch TR2 sequentially connected in series. The first terminal Va may be connected between the first control switch TR1 and the second diode CD2.

The current source rectifier 705 may include a third diode CD3, a third control switch TR3, a fourth diode CD4, and a fourth control switch TR4 sequentially connected in series. The second terminal Vb may be connected between the third control switch TR3 and the fourth diode CD4.

The current source rectifier 705 may include a fifth diode CD5, a fifth control switch TR5, a sixth diode CD6, and a sixth control switch TR6 sequentially connected in series. The third terminal Vc may be connected between the fifth control switch TR5 and the sixth diode CD6.

The first diode CD1, the third diode CD3, and the fifth diode CD5 may be connected to each other to provide a first output terminal.

The second control switch TR2, the fourth control switch TR4, and the sixth control switch TR6 may be connected to each other to provide a second output terminal. The first to sixth control switches TR1 to TR6 may be transistors.

The controller 130 may control a path of the pulse current Ip during the first falling period ①. The pulse current Ip may flow along a path including the first inductor 712, the second transistor Q2, the third inverter diode ID3, the seventh transistor Q7, the load Z_{L}, the second inverter diode ID2, and the sixth transistor Q6.

The controller 130 may control a path of the step current Is during the second falling period ③. The step current Is may flow along a path including the second inductor 722, the fourth transistor Q4, the third inverter diode ID3, the seventh transistor Q7, the load Z_{L}, the second inverter diode ID2, and the sixth transistor Q6.

When the pulse current Ip does not flow to the switching unit 750, the pulse current Ip may flow through the first inductor 712 and the first transistor Q1 to form a closed loop and operate in a free-wheeling mode.

When the step current Is does not flow to the switching unit 750, the step current Is may flow through the second inductor 722 and the second transistor Q13 to form a closed loop and operate in a free-wheeling mode.

Although the present disclosure has been described above with reference to exemplary embodiments thereof, it will be understood by those skilled in the art that various modifications and changes may be made to the present disclosure without departing from the spirit and scope of the present disclosure as set forth in the claims below.

### [Description of reference numerals]

100: Pulse generating apparatus
110: Pulse DC generator
120: Step waveform generator
130: Controller

## Claims

1. A pulse generating apparatus comprising:
a pulse DC generator configured to provide a pulse DC waveform to a capacitively coupled load;
a step waveform generator configured to provide a step waveform to the capacitively coupled load and connected parallel with the pulse DC generator; and
a controller configured to control the pulse DC waveform of the pulse DC generator and the step waveform of the step waveform generator,
wherein a waveform applied to the capacitively coupled load includes a first falling period in which a voltage decreases from a positive voltage to a negative first voltage, a first holding period in which the voltage is maintained at the negative first voltage for a predetermined time, a second falling period in which the voltage decreases from the first voltage to a second voltage, and a second holding period in which the voltage is maintained at the second voltage.

2. The pulse generating apparatus of claim 1, wherein the pulse DC generator includes:
a first source stage including at least one of a first voltage source and a first current source; and
a first switching stage configured to switch an output of the first source stage and output the switched output.

3. The pulse generating apparatus of claim 2, wherein the first switching stage is a half-bridge converter, a full-bridge converter, a three-level neutral point clamped (3L-NPC) converter, a three-level active neutral point clamped (3L-ANPC) converter, or a multi-level converter.

4. The pulse generating apparatus of claim 1, wherein the step waveform generator includes:
a second source stage including at least one of a second voltage source and a second current source; and
a second switching stage configured to switch an output of the second source stage and output the switched output.

5. The pulse generating apparatus of claim 4, wherein the second switching stage is a half-bridge converter, a full-bridge converter, a three-level neutral point clamped (3L-NPC) converter, a three-level active neutral point clamped (3L-ANPC) converter, or a multi-level converter.

6. The pulse generating apparatus of claim 1, wherein the pulse DC generator forms, at the capacitively coupled load, a first falling period in which a voltage decreases from a positive voltage to a negative first voltage, and
the step waveform generator provides, at the capacitively coupled load, a first holding period in which the voltage is maintained at the first voltage, a second falling period in which the voltage decreases from the first voltage to a second voltage, and a second holding period in which the voltage is maintained at the second voltage.

7. The pulse generating apparatus of claim 4, wherein the second current source provides a step current, and
the second switching stage provides the step current to the capacitively coupled load during the second falling period.

8. The pulse generating apparatus of claim 7, wherein the step current forms a ramp waveform at the capacitively coupled load, and
the ramp waveform provides an ion flux between a first energy peak resulting from the first voltage and a second energy peak resulting from the second voltage.

9. The pulse generating apparatus of claim 1, wherein the step waveform generator includes a plurality of sub-step waveform generators,
each of the sub-step waveform generators includes a second source stage including a second voltage source, and a second switching stage connected to the second voltage source, and
outputs of the sub-step waveform generators are connected to each other in a cascading manner.

10. The pulse generating apparatus of claim 1, wherein the pulse DC waveform generator includes a plurality of sub-pulse DC waveform generators,
each of the sub-pulse DC waveform generators includes a first source stage including a first voltage source, and a first switching stage connected to the first voltage source, and
outputs of the sub-pulse DC waveform generators are connected to each other in a cascading manner.

11. The pulse generating apparatus of claim 1, wherein the step waveform generator includes a plurality of sub-step waveform generators,
each of the sub-step waveform generators includes a second source stage including a second current source, and a second switching stage connected to the second current source, and
outputs of the sub-step waveform generators are connected to each other in parallel.

12. The pulse generating apparatus of claim 11, wherein the second switching stage includes:
a first transistor and a second transistor connected parallel to an output terminal of the second current source;
a first diode connected between the first transistor and ground; and
a second diode connected to the second transistor in series,
wherein an output of the second switching stage is provided through the second transistor and the second diode.

13. The pulse generating apparatus of claim 12, wherein the step waveform generator includes a first sub-step waveform generator and a second sub-step waveform generator,
the first sub-step waveform generator provides a first step current, and
the second sub-step waveform generator provides a second step current different from the first step current.

14. The pulse generating apparatus of claim 13, wherein the first step current forms a first ramp waveform at the capacitively coupled load, and
the second step current forms a second ramp waveform at the capacitively coupled load.

15. The pulse generating apparatus of claim 1, wherein the pulse DC generator includes:
a first source stage including a first current source; and
a first switching stage configured to switch an output of the first source stage and output the switched output, and
the step waveform generator includes:
a second source stage including a second current source; and
a second switching stage configured to switch an output of the second source stage and output the switched output.

16. The pulse generating apparatus of claim 15, wherein the pulse DC generator provides a pulse current, and
an application time of the pulse current is controlled to control an ion flux according to ion energy.

17. The pulse generating apparatus of claim 15, wherein the step waveform generator provides a step current, and
an application time of the step current is controlled to control an ion flux according to ion energy.

18. The pulse generating apparatus of claim 1, wherein the waveform applied to the capacitively coupled load further includes a third falling period in which the voltage decreases from the second voltage to a third voltage and a third holding period in which the voltage is maintained at the third voltage for a predetermined time.

19. A method of operating a pulse generating apparatus including a pulse DC generator configured to provide a pulse DC waveform to a capacitively coupled load, a step waveform generator configured to provide a step waveform to the capacitively coupled load and connected parallel with the pulse DC generator, and a controller configured to control the pulse DC waveform of the pulse DC generator and the step waveform of the step waveform generator, wherein a waveform applied to the capacitively coupled load includes a first falling period in which a voltage decreases from a positive voltage to a negative first voltage, a first holding period in which the voltage is maintained at the negative first voltage for a predetermined time, a second falling period in which the voltage decreases from the first voltage to a second voltage, and a second holding period in which the voltage is maintained at the second voltage, the method comprising:
setting the pulse DC waveform and the step waveform;
operating the pulse DC generator to form the pulse DC waveform at the capacitively coupled load; and
operating the step waveform generator to form the step waveform at the capacitively coupled load,
wherein the pulse DC waveform includes a first falling period in which a voltage decreases from a positive voltage to a negative first voltage, and
the step waveform includes a first holding period in which the voltage is maintained at the negative first voltage for a predetermined time, a second falling period in which the voltage decreases from the first voltage to a second voltage, and a second holding period in which the voltage is maintained at the second voltage.

20. A pulse generating apparatus comprising:
a pulse DC generator configured to provide a pulse DC waveform to a capacitively coupled load;
a step waveform generator configured to provide a step waveform to the capacitively coupled load and connected parallel with the pulse DC generator;
a switching unit configured to switch outputs of the pulse DC generator and the step waveform generator; and
a controller configured to control the pulse DC generator and the step waveform generator,
wherein a waveform applied to the capacitively coupled load includes a first falling period in which a voltage decreases from a positive voltage to a negative first voltage, a first holding period in which the voltage is maintained at the negative first voltage for a predetermined time, a second falling period in which the voltage decreases from the first voltage to a second voltage, and a second holding period in which the voltage is maintained at the second voltage.

21. The pulse generating apparatus of claim 20, wherein the pulse DC generator is branched from an output terminal of a current-source rectifier and connected to one end of a first inductor to generate a pulse current (Ip), and
the step waveform generator is branched from the output terminal of the current-source rectifier and connected to one end of a second inductor to generate a step current (Is).

22. The pulse generating apparatus of claim 21, wherein the pulse DC generator includes:
a first transistor having a source connected to the other end of the first inductor;
a second transistor having a source connected to the other end of the first inductor; and
a first diode connected to a drain of the first transistor in series,
wherein the first diode is connected to the one end of the first inductor, and
a drain of the second transistor is connected to an input terminal of the switching unit.

23. The pulse generating apparatus of claim 21, wherein the step waveform generator includes:
a third transistor having a source connected to the other end of the second inductor;
a fourth transistor having a source connected to the other end of the second inductor; and
a second diode connected to a drain of the third transistor in series,
wherein the second diode is connected to the one end of the second inductor, and
a drain of the fourth transistor is connected to an input terminal of the switching unit.

24. The pulse generating apparatus of claim 21, wherein the switching unit includes:
a fifth transistor connected to an output terminal of the pulse DC generator;
a sixth transistor connected to the fifth transistor in series;
a seventh transistor connected to the output terminal of the pulse DC generator;
an eighth transistor connected to the seventh transistor in series;
a first inverter diode disposed between the fifth transistor and the output terminal of the pulse DC generator;
a second inverter diode disposed between the fifth transistor and the sixth transistor;
a third inverter diode disposed between the seventh transistor and the output terminal of the pulse DC generator; and
a fourth inverter diode disposed between the seventh transistor and the eighth transistor,
wherein a node between the fifth transistor and the second inverter diode is connected to one end of the load, and a node between the seventh transistor and the fourth inverter diode is connected to the other end of the load.
